(19) Europäisches Patentamt

European Patent Office

Office européen des brevets

(11) **EP 1 326 327 A1**

(12) **DEMANDE DE BREVET EUROPEEN**

(43) Date de publication:
**09.07.2003 Bulletin 2003/28**

(51) Int Cl.⁷: **H03D 13/00**

(21) Numéro de dépôt: **02292890.7**

(22) Date de dépôt: **21.11.2002**

(84) Etats contractants désignés:
**AT BE BG CH CY CZ DE DK EE ES FI FR GB GR IE IT LI LU MC NL PT SE SK TR**
Etats d'extension désignés:
**AL LT LV MK RO SI**

(30) Priorité: **29.11.2001 FR 0115429**

(71) Demandeur: **ALCATEL**
**75008 Paris (FR)**

(72) Inventeurs:
• **Desgrez, Simon**
**31300 Toulouse (FR)**
• **Langrez, Dominique**
**31410 Lavernose Lacasse (FR)**

(74) Mandataire: **Smith, Bradford Lee et al**
**Compagnie Financière Alcatel,**
**Département de Propriété Industrielle,**
**5, rue Noel Pons**
**92734 Nanterre Cedex (FR)**

(54) **Détecteur de phase à échantillonnage**

(57) L'invention propose un détecteur de phase à échantillonnage, dans lequel un premier transistor d'échantillonnage détermine la phase d'un signal à échantillonner avec une très grande sensibilité. Un signal représentatif de la phase est fourni à un deuxième étage d'échantillonnage. Le deuxième étage d'échantillonnage assure le maintien de la valeur de phase déterminée.

L'invention permet notamment d'obtenir un signal de phase à la fois plus stable et plus sensible.

L'invention a également pour objet un procédé et un oscillateur mettant en oeuvre le procédé.

FIG_1

EP 1 326 327 A1

## Description

La présente invention porte sur les détecteurs de phase, et en particulier sur les détecteurs de phase à échantillonnage.

La revue Microwave & RF de juillet 1993 décrit pages 103 à 111 un détecteur de phase à échantillonnage à circuit hybride. Ce détecteur est constitué d'une diode SRD (Step Recovery Diode) et d'un échantillonneur. La diode devient passante durant un basculement de polarité à ses bornes et fournit alors une impulsion à une entrée de l'échantillonneur. Cette impulsion constitue une référence basse fréquence. L'échantillonneur reçoit également un signal haute fréquence ou radiofréquence à échantillonner. La fréquence du signal à échantillonner est N fois supérieure à la fréquence des impulsions de référence, N étant un entier. L'échantillonneur compare le signal d'impulsion au signal à échantillonner. Lorsque le front montant de l'impulsion égale le signal à échantillonner, le niveau de tension correspondant est fourni sous forme de niveau constant en sortie d'échantillonneur. On obtient ainsi en sortie une tension proportionnelle à la phase du signal radiofréquence par rapport à un signal de référence. L'échantillonneur comprend un transistor d'échantillonnage présentant une largeur de grille intermédiaire. La largeur de grille intermédiaire utilisée fournit un compromis entre une bonne sensibilité de phase et une bonne tenue du signal de sortie continu de l'échantillonneur.

Ce dispositif de détection de phase par échantillonnage présente des inconvénients. D'une part, le circuit hybride implique un encombrement important. D'autre part, la diode SRD nécessite une puissance d'alimentation importante pour générer des impulsions adéquates. Ces inconvénients sont particulièrement handicapants dans des applications aérospatiales. Le prix de revient de ce type de circuit est également élevé. Ce type de circuit nécessite également de nombreux réglages avant sa mise en service.

Le document WO-A-99/18691 décrit un comparateur de phase totalement numérique. Ce comparateur fournit la phase entre deux signaux d'horloge. Un signal analogique radiofréquence est numérisé. Son approximation numérique est comparée à un autre modèle numérique. La différence de phase entre les signaux numériques est ensuite codée sous forme de mot numérique en fonction de son amplitude.

Le document Patent abstract of Japan JP-02141009, intitulé "Sampling phase detector" décrit un circuit intégré monolithique de détection de phase à échantillonnage. Ce circuit est réalisé sur un substrat Ga-As. Ce circuit utilise la commutation d'un transistor à effet de champs provoquée par des circuits de limitation d'amplitude, un circuit de retard et une porte ET. Deux signaux sont combinés dans une porte NOR afin de générer une impulsion à une fréquence de référence.

Cet échantillonneur présente des inconvénients. Le transistor à effet de champs utilisé présente à la fois une résistance de blocage trop faible et une résistance de passage trop élevée. La sensibilité en phase et la stabilité du signal de sortie sont ainsi insuffisantes.

Il existe donc un besoin pour un détecteur de phase à échantillonnage résolvant un ou plusieurs de ces inconvénients. Il existe également un besoin pour un oscillateur local incluant un détecteur de phase tel que revendiqué.

L'invention propose ainsi un détecteur de phase à échantillonnage, comprenant un premier transistor d'échantillonnage présentant une entrée de signal à échantillonner à une fréquence RF, une entrée de signal de commande, une sortie fournissant un premier signal échantillonné en fonction de la phase entre le signal à échantillonner et le signal de commande, une résistance de passage entre l'entrée et la sortie inférieure à $(0,1 * 10^{-12} * RF)^{-1}$, -un deuxième transistor d'échantillonnage présentant une entrée sur laquelle est appliquée le premier signal échantillonné, une entrée de signal de commande, une sortie de deuxième signal échantillonné, le deuxième transistor présentant une résistance de blocage entre l'entrée et la sortie supérieure à 100 Ohms.

Selon une variante, les transistors d'échantillonnage sont des transistors à effet de champ, le drain du premier transistor est l'entrée de signal à échantillonner, la grille du premier transistor est l'entrée de signal de commande, la source du premier transistor est la sortie du signal échantillonné, le drain du deuxième transistor est l'entrée du premier signal échantillonné, la grille du deuxième transistor est l'entrée de signal de commande, la source du deuxième transistor est la sortie du deuxième signal échantillonné, la résistance de blocage entre l'entrée et la sortie du deuxième transistor est supérieure à la résistance de blocage entre l'entrée et la sortie du premier transistor.

Selon encore une variante, la source du premier transistor présente un premier condensateur en parallèle, la source du deuxième transistor présente un deuxième condensateur en parallèle.

Selon une autre variante, le détecteur comprend en outre un générateur de signaux de commande fournissant des créneaux aux entrées de signaux de commande des premier et deuxième transistors.

Selon encore une autre variante, le générateur de signaux de commande est réalisé monolithique avec les transistors.

On peut encore prévoir que le générateur de signaux de commande présente une entrée de signal alternatif de référence, un circuit inverseur connectant l'entrée de signal alternatif de référence à l'entrée de signal de commande du premier ou du deuxième transistor.

Selon une variante, le circuit inverseur comprend une porte logique SCFL.

Selon une autre variante, le circuit inverseur comprend 3 ou 4 étages d'inversion.

Selon encore une variante, le générateur de signaux de commande fournit des signaux de commande en opposition de phase respectivement aux premier et deuxième transistors.

L'invention a également pour objet un oscillateur local comprenant le détecteur de phase tel que revendiqué.

L'invention a encore pour objet un procédé de détection de phase par échantillonnage comprenant les étapes de fourniture d'un premier transistor d'échantillonnage, présentant une résistance de passage entre son entrée et sa sortie inférieure à $(0,1 * 10^{-12} * RF)^{-1}$, fourniture d'un deuxième transistor d'échantillonnage, présentant une résistance de blocage entre son entrée et sa sortie supérieure à 100 Ohms, échantillonnage du signal à échantillonner dans le premier transistor d'échantillonnage, échantillonnage du signal échantillonné dans le deuxième transistor d'échantillonnage.

Selon une variante, le procédé comprend en outre les étapes d'application de créneaux de commande sur transistors pour déclencher les étapes d'échantillonnage.

Selon encore une variante, les créneaux de commande sont en opposition de phase.

Selon une autre variante, le procédé comprend en outre des étapes de lissage des signaux échantillonnés.

D'autres caractéristiques et avantages de l'invention apparaîtront à la lecture de la description qui suit de modes de réalisation de l'invention donnée à titre d'exemple et en référence aux dessins qui montrent :

- figure 1, une représentation schématique d'un détecteur de phase par échantillonnage selon l'invention ;
- figure 2, une représentation de la structure d'un bloc d'échantillonnage et de blocs associés ;
- figure 3, un circuit d'interface d'entrée d'un générateur de signaux de commande ;
- figure 4, un exemple d'un étage inverseur d'un premier type ;
- figure 5, un exemple d'un étage d'inverseur d'un second type ;
- figure 6, un signal de référence et deux signaux de commande en opposition de phase ;
- figure 7, les signaux respectifs à la sortie des transistors d'échantillonnage ;
- figure 8, un exemple d'oscillateur mettant en oeuvre un détecteur de phase de l'invention.

L'invention propose un détecteur de phase à échantillonnage, dans lequel un premier transistor d'échantillonnage détermine la phase d'un signal à échantillonner avec une très grande sensibilité. Un signal représentatif de la phase est fourni à un deuxième étage d'échantillonnage. Le deuxième étage d'échantillonnage assure le maintien de la valeur de phase déterminée et l'isolation de la sortie.

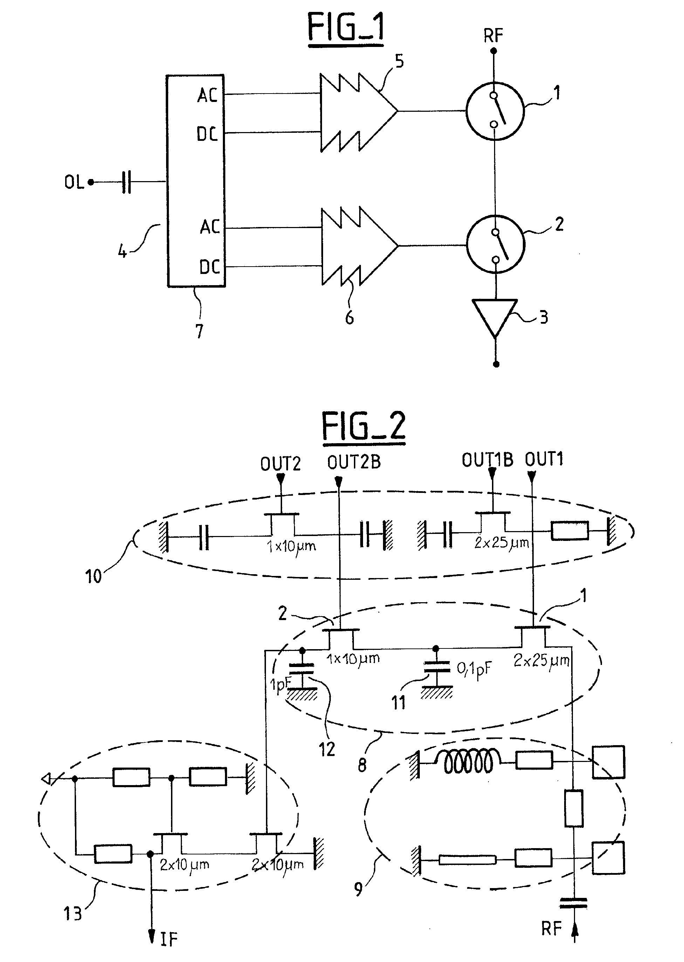

La figure 1 représente de façon schématique un détecteur de phase selon l'invention. Le détecteur de phase comprend une entrée d'un signal de référence OL, et une entrée d'un signal à échantillonner RF. Il fournit en sortie un signal représentatif de la phase entre le signal de référence et le signal à échantillonner.

Le détecteur de phase comprend un générateur de signaux de commande 4 et deux transistors d'échantillonnage 1 et 2. Ce générateur de signaux de commande 4 reçoit sur une entrée le signal de référence OL. Ce signal est transformé en signaux de commande appropriés respectivement dans des chaînes d'inverseur 5 et 6. Les signaux de commande présentent la même fréquence que les signaux de référence OL. Les signaux de commande ont par exemple une fréquence comprise entre 50 et 100MHz. Les chaînes d'inverseur 5 et 6 fournissent les signaux de commande respectifs à des entrées de signal de commande respectives des transistors 1 et 2.

Bien que les transistors 1 et 2 représentés soient des transistors FET, on peut bien entendu utiliser des transistors bipolaires ou tout autre transistor adéquat. L'utilisation de transistors FET présente un certain nombre d'avantages. Les transistors FET présentent notamment des temps de commutation très courts et une consommation électrique très réduite. L'utilisation de transistors bipolaires permet cependant d'échantillonner un signal de plus haute fréquence.

En première approximation, un transistor échantillonneur se comporte comme une résistance variable. Lorsqu'un transistor FET est bloqué, la résistance drain-source prend une valeur Roff qui est d'autant plus élevée que la largeur ou le développement de grille est petit, et vice-versa pour le transistor passant présentant une valeur Ron. On pourra ainsi jouer sur les largeurs ou les développements de grille des transistors respectifs pour adapter les résistances de blocage et passante à des niveaux souhaités.

On utilise un transistor 1 présentant de préférence une résistance drain-source à l'état passant inférieure à un niveau prédéterminé. Le niveau est par exemple déterminé par la formule suivante :

$$R_{ON} T1 < (0,1 * 10^{-12} * RF)^{-1}$$

RF étant la fréquence du signal à échantillonner.

On peut encore envisager de définir le niveau maximal de résistance par la formule suivante :

$$R_{ON} T1 < (1 * 10^{-12} * RF)^{-1}$$

L'utilisation d'une telle valeur de résistance permet d'échantillonner le signal avec une atténuation d'amplitude réduite. La sensibilité de l'échantillonneur est ainsi accrue. En outre, plus la résistance de passage du transistor 1 est basse, et plus la fréquence du signal à échantillonner peut être élevée.

La résistance de passage minimale est également de préférence obtenue par la formule suivante :

$$R_{ON} \, T1 > (100 \, *10^{-12} * \, RF)^{-1}$$

Le transistor 1 présente une entrée de signal radiofréquence à échantillonner RF sur son drain. Le signal à échantillonner présente une fréquence N fois supérieure à la fréquence des signaux de commande, N étant un entier. La fréquence du signal à échantillonner est par exemple comprise entre 1 et 20GHz.

Le signal de commande du transistor 1 est appliqué sur la grille de ce transistor 1. Lorsque la tension du signal de commande dépasse la tension de seuil de la grille du transistor 1, le transistor 1 devient passant. Le transistor émet alors en sortie, c'est-à-dire sur sa source, un premier signal échantillonné continu. Ce premier signal échantillonné est représentatif de la différence de phase entre le signal de commande et le signal à échantillonner RF.

La source du transistor 1 est par exemple connectée au drain du transistor 2. On peut ainsi fournir le premier signal échantillonné à une entrée du deuxième transistor 2. Le signal de commande du transistor 2 est appliqué sur la grille de ce transistor 2. Lorsque la tension du signal de commande dépasse la tension de seuil de la grille du transistor 2, le transistor 2 devient passant. Le transistor 2 émet alors en sortie, c'est-à-dire sur sa source, un deuxième signal échantillonné sensiblement continu. Ce deuxième signal échantillonné est représentatif de différence de phase entre le signal de référence et le signal à échantillonner RF.

On utilise de préférence un transistor 2 présentant une résistance de blocage drain-source supérieure à une valeur de 100 Ohms, et plus particulièrement supérieure à une valeur de 500 Ohms. Une telle valeur de résistance permet d'obtenir une stabilité et un maintien du deuxième signal échantillonné améliorée. On peut également envisager une valeur de 1000 Ohms. On utilise par exemple une valeur de résistance de blocage de 2500 Ohms dans l'exemple. On utilise également de préférence un transistor 2 présentant une résistance de passage drain-source supérieure à 100 Ohms pour filtrer les perturbations potentielles provenant du signal radiofréquence à échantillonner. Le deuxième signal échantillonné n'est ainsi pas influencé ni parasité par le signal à échantillonner.

Le bloc 8 de la figure 2 représente un mode de réalisation d'un circuit d'échantillonnage. Ce circuit peut comprendre un condensateur 11 en parallèle sur la source du transistor 1. On peut également prévoir de monter un condensateur 12 en parallèle sur la source du transistor 2. Pour le dimensionnement des condensateurs 11 et 12, on tient bien entendu compte des valeurs de résistance drain-source de passage des transistors 1 et respectifs. On adapte ainsi la résistance de passage/blocage et la capacité à une constante de temps souhaitée pour un ensemble transistor-condensateur.

Pour l'ensemble formé par le transistor 1 et le condensateur 11, on utilise une constante de temps pour le transistor 1 à l'état passant adaptée à la fréquence du signal à échantillonner.

On peut également de façon générale remplacer les condensateurs 11 et 12 par des éléments remplissant une fonction identique de lissage et de maintien, tels que des transistors ou des diodes intégrés de façon appropriée.

La capacité du condensateur 11 est adaptée pour fournir une bonne stabilité en tension du premier signal échantillonné. Ce condensateur a également une capacité adaptée pour permettre d'échantillonner un signal à une fréquence élevée avec une bonne sensibilité de phase. On utilise dans l'exemple une capacité de 0,1 pF.

Le condensateur 12 présente une capacité adaptée pour fournir une excellente stabilité en tension du deuxième signal échantillonné continu. Ce condensateur présente également de préférence une capacité adaptée pour permettre un temps d'échantillonnage suffisant. On utilise dans l'exemple une capacité de 1 pF.

On va maintenant décrire la génération et le fonctionnement des signaux de commande. On peut prévoir que le générateur de signaux 4 fournisse des signaux de commande sous forme de créneaux aux premier et deuxième transistors 1 et 2. Il était supposé auparavant qu'une impulsion très courte était indispensable pour assurer une bonne sensibilité de phase. L'inventeur a mis en évidence qu'il n'était pas indispensable d'utiliser des signaux de commande sous forme d'impulsions pour obtenir un échantillonnage satisfaisant. L'inventeur propose plutôt d'utiliser un créneau présentant un front descendant présentant un temps de commutation très court. Les circuits de génération de créneaux sont en effet plus simples et moins coûteux que les circuits de génération d'impulsion. On va maintenant décrire un circuit de génération de signaux de commande à temps de commutation réduits.

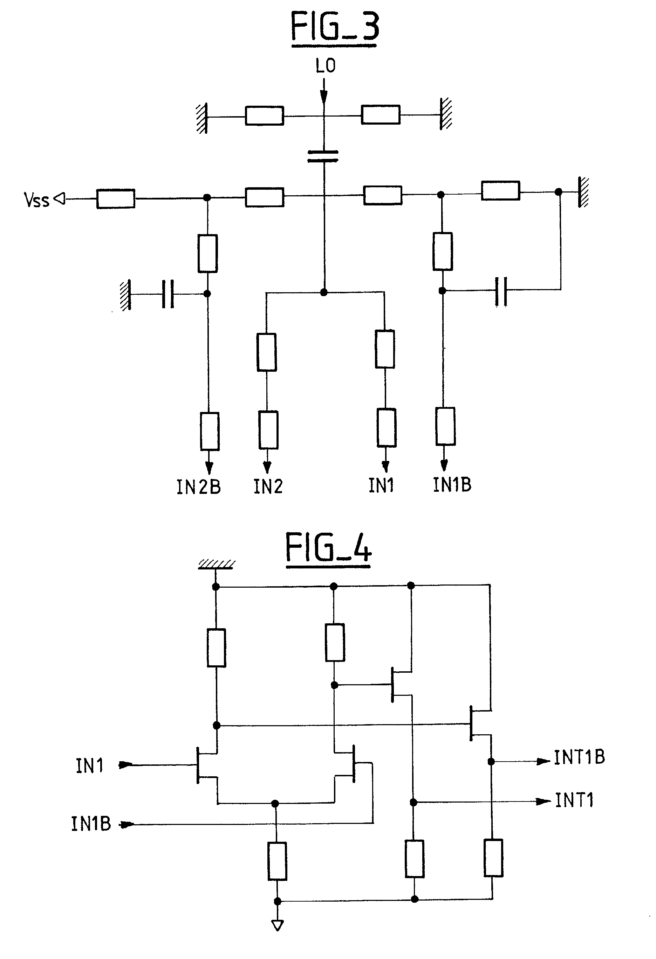

Le générateur de signaux de commande 4 peut présenter une interface d'entrée 7, telle que celle représentée à la figure 3. Ce circuit reçoit en entrée un signal alternatif de référence OL, habituellement sinusoïdal, et fournit en sortie quatre signaux, désignés par IN1, IN1B, IN2 et IN2B. Les signaux IN1 et IN2 sont des signaux alternatifs, qui présentent une composante continue. L'amplitude de la composante continue est adaptée aux niveaux requis par des portes logiques placées dans les inverseurs. Les signaux IN1B et IN2B sont des signaux continus. Ces signaux servent de référence de déclenchement des portes logiques des inverseurs 5 et 6.

Les inverseurs 5 et 6 transforment le signal de référence, par exemple un signal sinusoïdal, en un signal de commande sous forme de créneaux respectivement pour les transistors 1 et 2. Les inverseurs 5 et 6 connectent par exemple l'entrée de signal de référence à une grille d'un transistor respectif. De façon générale on prévoit que les inverseurs 5 et 6 utilisent des portes logiques inverseuses SCFL (portes logiques utilisant des transistors à effet de champ à sources couplées). De telles portes logiques présentent en effet des temps de commutation réduits, ce qui permet d'augmenter la sensibilité de phase comme on l'a décrit précédemment. Ainsi, même pour des signaux à échantillonner à des fréquences de l'ordre de 20 GHz ou plus, on peut obtenir une sensibilité de phase satisfaisante dans le détecteur de phase. Ces portes logiques présentent en outre une consommation électrique réduite, ce qui est particulièrement avantageux pour des applications aéronautiques ou spatiales. Le circuit représenté comprend des composants logiques simples et en nombre réduit. Un tel circuit est ainsi peu sensible aux radiations, ce qui est particulièrement avantageux dans des applications spatiales et aéronautiques.

Les inverseurs 5 et 6 sont de préférence réalisés sous forme de chaînes d'étages inverseurs. Plus le nombre d'étages d'inverseurs est élevé, et plus le temps de commutation des signaux de commande est réduit. Le nombre d'étages d'inverseurs est également adapté en fonction de la forme d'onde du signal de référence. Si le signal de référence est proche d'un créneau, le nombre d'étages d'inverseurs nécessaires pour obtenir un temps de commutation donné est réduit. On utilise dans l'exemple quatre étages d'inverseurs pour transformer le signal de référence en des créneaux. On a constaté en pratique que ce nombre d'étages d'inverseurs fournit à la fois un temps de commutation et une consommation électrique réduit.

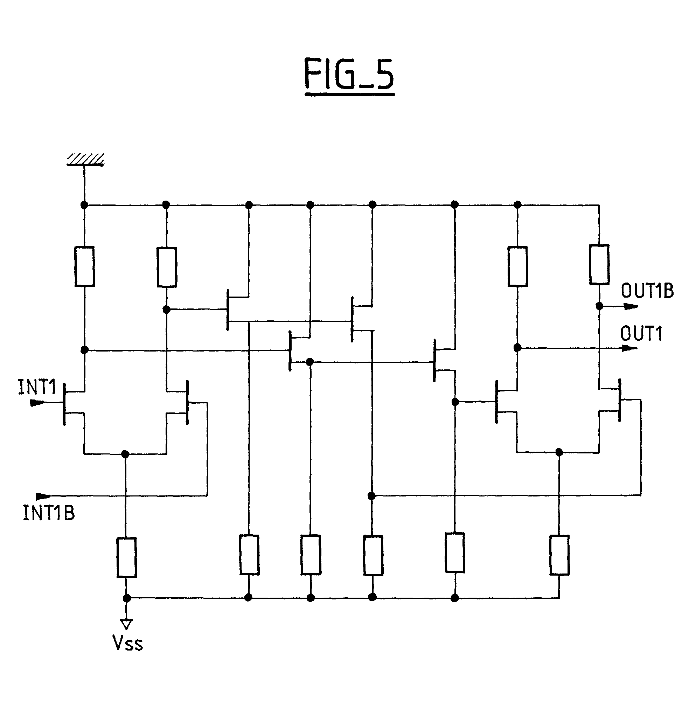

Une chaîne d'étages inverseurs comprend par exemple en série, en allant de l'entrée du signal de référence jusqu'à l'entrée du signal de commande, trois étages inverseurs, tels que ceux représentés à la figure 4, suivis d'un étage inverseur tel que celui représenté à la figure 5. De telles chaînes de circuits inverseurs présentent un bruit de phase et surtout une sensibilité de phase aux radiations réduits.

La figure 4 représente un étage d'inverseur recevant sur ses entrées les signaux IN1 et IN1B. Ces signaux traversent l'étage d'inversion. L'étage d'inversion fournit en sortie les signaux INT1 et INT1B. Ces étages d'inverseurs ont pour fonction principale de transformer le signal de référence en créneaux. On peut utiliser des niveaux de tension réduits dans ces étages d'inverseurs afin d'en réduire la consommation électrique.

La figure 5 représente un dernier étage d'inverseur servant d'interface avec un transistor d'échantillonnage. Cet étage d'échantillonnage adapte le signal de commande au type de transistor échantillonneur auquel il est connecté. Cet étage d'inverseur peut ainsi avoir une fonction d'amplification des signaux provenant des étages d'inverseurs précédents. Il fournit ainsi en sortie des niveaux de commande OUT1 et OUT1B dont les niveaux haut et bas sont conformes aux exigences du transistor d'échantillonnage correspondant. La sortie OUT1 est connectée par exemple au transistor 1 comme cela est représenté à la figure 2.

On observe en outre à la figure 2, que les sorties OUT1 B et OUT2B des inverseurs 5 et 6 sont connectées à un circuit de compensation de charge 10. Le circuit de compensation de charge 10 présente une structure similaire à la structure d'échantillonnage 8. Le circuit 10 permet d'équilibrer les charges du dernier étage inverseur, respectivement pour les inverseurs 5 et 6. Ce circuit est particulièrement utile lorsqu'on utilise un dernier étage d'inverseur dont les deux transistors sont équilibrés. On évite ainsi une augmentation du temps de commutation pouvant résulter d'un déséquilibre.

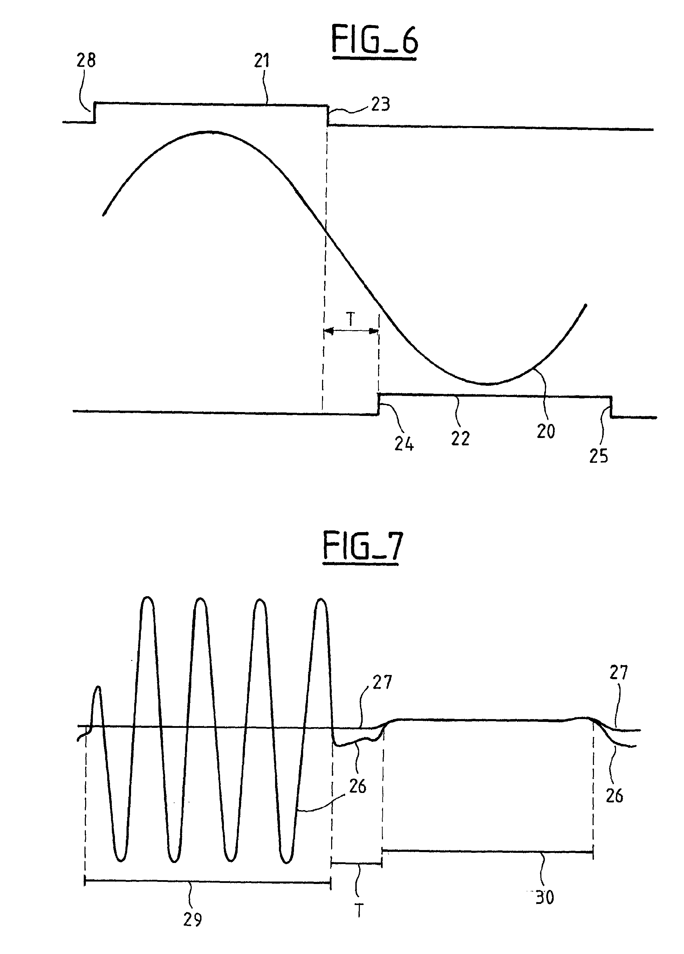

En référence à la figure 6, on va maintenant donner des précisions concernant les signaux de commande. La courbe 20 représente un signal de référence sinusoïdal fourni au générateur de signaux de commande. Les courbes 21 et 22 représentent les signaux de commande en créneaux à la sortie des inverseurs 5 et 6 respectivement. On constate que les signaux de commande 21 et 22 sont en opposition de phase. On constate également que les états hauts des signaux de commande ne se chevauchent pas, dans la mesure où il existe une période T entre le front descendant 23 du signal 21 et le front montant 24 du signal 22. De façon générale, un front montant d'un signal de commande rend le transistor respectif passant. Un front descendant d'un signal de commande rend le transistor respectif bloqué.

La justification de ces caractéristiques des signaux de commande va maintenant être décrite en référence à la figure 7. Le signal 26 correspond au signal à la source du transistor 1. Le signal 27 correspond au signal à la source du transistor 2. La portion du signal 26 durant la période 29 correspond à l'état passant du transistor 1. Cette portion correspond à la période allant du front montant 28 au front descendant 23 du signal de commande 21. Le signal 26 correspond sensiblement au signal à échantillonner durant la période 29. Simultanément, le signal de commande 22 est à l'état bas. Le transistor 2 est ainsi maintenu à l'état bloqué et le signal 27 présente ainsi un niveau continu.

Durant la période T, les transistors 1 et 2 sont maintenus bloqués. Cette période correspond à la période T entre le front descendant du signal 21 et le front montant du signal 22. Lors du front descendant du signal 21, le transistor fournit en sortie une tension instantanée en continu proportionnelle au signal à échantillonner. Le signal 26 à la sortie du transistor 1 est lissé par le condensateur 11. Ainsi, un signal sensiblement continu est appliqué au drain du transistor 2 pendant la période T. La période T est comprise de préférence dans une plage de ]0 % ;99 %[ de la période d'échantillonnage.

Lors du front montant du signal 22, le transistor 2 devient passant. Il échantillonne alors le signal provenant du transistor 1. Du fait des propriétés du transistor 2 décrites, il maintient sur sa source un signal continu de différence de phase très stable représentatif de la différence de phase entre le signal de référence et le signal à échantillonner. Ce signal est fourni pendant la période 30, c'est-à-dire entre le front montant 24 et le front descendant 25 du signal de commande 22. Ce signal de différence de phase est ensuite lissé par le condensateur 12 comme on l'a décrit précédemment.

Du fait de l'absence de recouvrement entre les signaux de commande 21 et 22, le transistor 2 n'est pas parasité par les ondulations du signal à échantillonner. Le dispositif et le procédé utilisés ne nécessitent pas d'utiliser des impulsions de commande pour obtenir précisément la différence de phase.

On peut en outre disposer en série un circuit tampon 13 à la sortie du transistor 2. Ce circuit supprime l'influence de l'impédance de sortie sur le transistor 2. Ainsi, l'impédance de sortie n'influence pas l'échantillonnage. On peut également prévoir que le tampon présente un gain continu supérieur à 1, de façon à augmenter la sensibilité de la mesure.

Selon une variante préférée de l'invention, le générateur de signaux de commande et les transistors d'échantillonnage sont réalisés de façon monolithique. Ces éléments peuvent par exemple être formés sous forme d'un unique circuit intégré sur un substrat Ga-As. Cette mise en oeuvre permet de réduire le volume global, le prix et la consommation électrique du détecteur de phase à échantillonnage. En outre, la réalisation sous forme de circuit intégré monolithique permet d'éliminer le temps de réglage après la conception et la fabrication, ce qui facilite la conception du détecteur.

Un signal de référence présentant une fréquence de l'ordre de 50 à 100 MHz, peut être généré par exemple par un circuit extérieur utilisant un quartz. On peut ainsi générer un signal de référence précis avec des composants largement diffusés et d'un coût réduit.

Le détecteur de phase par échantillonnage peut par exemple être appliqué dans un oscillateur. Les oscillateurs, utilisés en tant que sources de fréquence, utilisent par exemple la phase déterminée par le détecteur. La phase peut ainsi être introduite dans une boucle d'asservissement en fréquence de l'oscillateur. Il est ainsi possible de générer des fréquences très stables avec un oscillateur muni d'un détecteur de phase à échantillonnage selon l'invention.

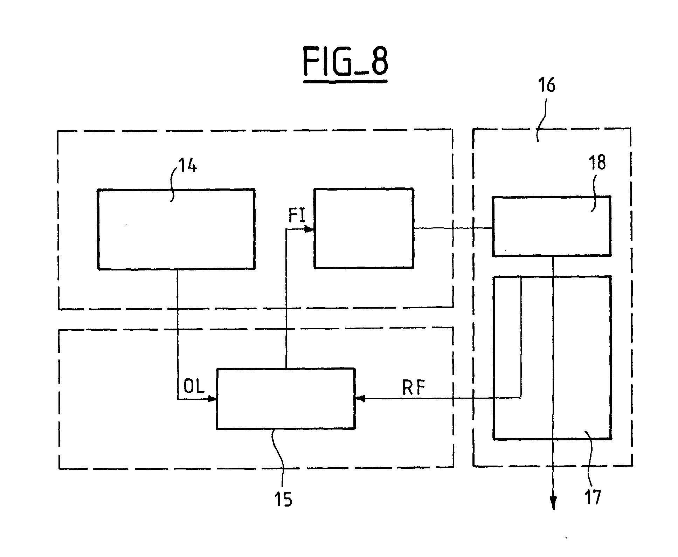

La figure 8 représente un exemple d'oscillateur mettant en oeuvre un détecteur de phase de l'invention. L'oscillateur comprend ainsi un oscillateur à tension contrôlée 16 dit VCO, un détecteur de phase à échantillonnage 15 et un générateur de signal de référence. Les oscillateurs VCO présentent habituellement un bruit de phase important, c'est-à-dire une faible stabilité en fréquence. L'oscillateur 16 présente une interface de sortie 17 qui fournit un signal à une fréquence donnée à un appareil annexe et au détecteur de phase 15. Le détecteur de phase 15 échantillonne le signal reçu en fonction du signal de référence. Le détecteur de phase 15 fournit le signal RF représentatif de la phase à un élément de commande 18. La commande 18 intervient sur l'interface de sortie pour corriger le signal généré.

Les présents modes de réalisation et exemples doivent être considérés comme ayant été présentés à titre illustratif et non restrictif et l'invention n'est pas censée être limitée aux détails fournis ici mais peut être modifiée en restant dans le cadre de la portée des revendications annexées. On peut par exemple envisager de remplacer des transistors bipolaire à commande par des intensités adéquates et présentant respectivement des résistances de passage ou respectivement de blocage entre collecteur et émetteur déterminées comme décrit précédemment pour les transistors à effet de champs.

## Revendications

1. Détecteur de phase à échantillonnage, comprenant :

   - un premier transistor (1) d'échantillonnage présentant :

     - une entrée de signal à échantillonner à une fréquence RF ;
     - une entrée de signal de commande (OUT1);
     - une sortie fournissant un premier signal échantillonné en fonction de la phase entre le signal à échantillonner et le signal de commande ;
     - une résistance de passage entre l'entrée et la sortie inférieure à $(0,1 * 10^{-12} * RF)^{-1}$

   - un deuxième transistor (2) d'échantillonnage présentant :

     - une entrée sur laquelle est appliquée le premier signal échantillonné ;
     - une entrée de signal de commande (OUT2B);
     - une sortie de deuxième signal échantillonné ;
     - le deuxième transistor présentant une résistance de blocage entre l'entrée et la sortie supérieure à 100 Ohms.

2. Le détecteur de la revendication 1, **caractérisé en ce que** :

   - les transistors d'échantillonnage sont des transistors à effet de champ ;
   - le drain du premier transistor est l'entrée de signal à échantillonner ;

- la grille du premier transistor est l'entrée de signal de commande ;
- la source du premier transistor est la sortie du signal échantillonné ;
- le drain du deuxième transistor est l'entrée du premier signal échantillonné ;
- la grille du deuxième transistor est l'entrée de signal de commande ;
- la source du deuxième transistor est la sortie du deuxième signal échantillonné ;
- la résistance de blocage entre l'entrée et la sortie du deuxième transistor est supérieure à la résistance de blocage entre l'entrée et la sortie du premier transistor.

3. Le détecteur de la revendication 2, **caractérisé en ce que** :

   - la source du premier transistor présente un premier condensateur (11) en parallèle ;
   - la source du deuxième transistor présente un deuxième condensateur (12) en parallèle.

4. Le détecteur de l'une des revendications 1 à 3, **caractérisé en ce qu'**il comprend en outre un générateur de signaux de commande (4) fournissant des créneaux aux entrées de signaux de commande des premier et deuxième transistors.

5. Le détecteur de la revendication 4, **caractérisé en ce que** le générateur de signaux de commande (4) est réalisé monolithique avec les transistors.

6. Le détecteur de l'une des revendications 4 ou 5, **caractérisé en ce que** le générateur de signaux de commande présente :

   - une entrée de signal alternatif de référence ;
   - un circuit inverseur (5, 6) connectant l'entrée de signal alternatif de référence à l'entrée de signal de commande du premier ou du deuxième transistor.

7. Le détecteur de la revendication 6, **caractérisé en ce que** le circuit inverseur comprend une porte logique SCFL.

8. Le détecteur de la revendication 6 ou 7, **caractérisé en ce que** le circuit inverseur comprend 3 ou 4 étages d'inversion.

9. Le détecteur de l'une des revendications 4 à 8, **caractérisé en ce que** le générateur de signaux de commande fournit des signaux de commande (21, 22) en opposition de phase respectivement aux premier et deuxième transistors .

10. Oscillateur local comprenant le détecteur de phase de l'une des revendications précédentes.

11. Procédé de détection de phase par échantillonnage comprenant les étapes de:

    - fourniture d'un premier transistor d'échantillonnage (1), présentant une résistance de passage entre son entrée et sa sortie inférieure à $(0,1 * 10^{-12} * RF)^{-1}$;
    - fourniture d'un deuxième transistor d'échantillonnage (2), présentant une résistance de blocage entre son entrée et sa sortie supérieure à 100 Ohms ;
    - échantillonnage du signal à échantillonner dans le premier transistor d'échantillonnage ;
    - échantillonnage du signal échantillonné dans le deuxième transistor d'échantillonnage.

12. Le procédé de la revendication 11, **caractérisé en ce qu'**il comprend en outre les étapes de :

    - application de créneaux de commande (21, 22) sur transistors pour déclencher les étapes d'échantillonnage.

13. Le procédé de la revendication 12, **caractérisé en ce que** les créneaux de commande sont en opposition de phase.

14. Le procédé de l'une des revendications 11 à 13, **caractérisé en ce qu'**il comprend en outre des étapes de lissage des signaux échantillonnés.

# FIG_1

RF

AC

DC

5

1

OL

AC

DC

4

2

6

7

3

# FIG_2

OUT2    OUT2B    OUT1B   OUT1

1×10µm           2×25µm

10

2                                         1

1×10µm           0,1pF        2×25µm

1pF

11

12

8

9

2×10µm      2×10µm

13

IF

RF

## FIG_3

IN2B    IN2    IN1    IN1B

## FIG_4

IN1

IN1B

INT1B

INT1

# FIG_5

INT1

INT1B

Vss

OUT1B

OUT1

## FIG_6

## FIG_7

# FIG_8

**Office européen**
**des brevets**

**RAPPORT DE RECHERCHE EUROPEENNE**

Numéro de la demande

EP 02 29 2890

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 5 339 459 A (T. SCHILTZ) 16 août 1994 (1994-08-16) * colonne 2, ligne 15 - ligne 23 * * colonne 2, ligne 33 - ligne 35 * * colonne 3, ligne 50 - ligne 58 * * colonne 4, ligne 19 - ligne 33 * * colonne 7, ligne 30 - colonne 9, ligne 2; figure 5 * --- | 1-14 | H03D13/00 |
| Y | US 4 323 796 A (M. LATHROPE) 6 avril 1982 (1982-04-06) * colonne 2, ligne 40 - colonne 5, ligne 4; figure 1 * --- | 1-14 | |
| A | US 5 017 924 A (C. GUIBERTEAU) 21 mai 1991 (1991-05-21) * colonne 4, ligne 34 - ligne 42; revendication 1; figures 1,3 * --- | 1-14 | |
| A | US 5 187 390 A (B. SCOTT) 16 février 1993 (1993-02-16) * colonne 5, ligne 32 - colonne 9, ligne 44; figures 2,3 * --- | 1 | DOMAINES TECHNIQUES RECHERCHES (Int.Cl.7) H03D G11C |
| A | T. SOWLATI: "PHASE CORRECTING FEEDBACK SYSTEM FOR CLASS E POWER AMPLIFIER" IEEE JOURNAL OF SOLID STATE CIRCUITS, vol. 32, no. 4, 1 avril 1997 (1997-04-01), pages 544-550, XP000659735 NEW YORK ,US * page 547, colonne 2, ligne 22 - page 548, colonne 1, ligne 15; figure 6 * --- -/-- | 1 | |

Le présent rapport a été établi pour toutes les revendications

| Lieu de la recherche | Date d'achèvement de la recherche | Examinateur |
|---|---|---|
| LA HAYE | 14 mai 2003 | Butler, N |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

      

& : membre de la même famille, document correspondant

EPO FORM 1503 03.82 (P04C02)

<table>
<tr><td>Office européen<br>des brevets</td><td>RAPPORT DE RECHERCHE EUROPEENNE</td><td>Numéro de la demande<br>EP 02 29 2890</td></tr>
</table>

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (Int.Cl.7) |
|---|---|---|---|
| A | M. BRUUN: "A 2-10 GHZ GAAS MMIC OPTO-ELECTRONIC PHASE DETECTOR FOR OPTICAL MICROWAVE SIGNAL GENERATORS"<br>IEEE MTT-S DIGEST,<br>23 mai 1994 (1994-05-23), pages 499-502,<br>XP000527324<br>NEW YORK,US<br>* page 499, colonne 2, ligne 12 - page 501, colonne 2, ligne 27; figure 2 *<br>----- | 1 | |
| | | | **DOMAINES TECHNIQUES<br>RECHERCHES (Int.Cl.7)** |

Le présent rapport a été établi pour toutes les revendications

| Lieu de la recherche | Date d'achèvement de la recherche | Examinateur |
|---|---|---|
| LA HAYE | 14 mai 2003 | Butler, N |

CATEGORIE DES DOCUMENTS CITES

X : particulièrement pertinent à lui seul
Y : particulièrement pertinent en combinaison avec un
  autre document de la même catégorie
A : arrière-plan technologique
O : divulgation non-écrite
P : document intercalaire

T : théorie ou principe à la base de l'invention
E : document de brevet antérieur, mais publié à la
  date de dépôt ou après cette date
D : cité dans la demande
L : cité pour d'autres raisons

 

& : membre de la même famille, document correspondant

EPO FORM 1503 03.82 (P04C02)

# EP 1 326 327 A1

**ANNEXE AU RAPPORT DE RECHERCHE EUROPEENNE
RELATIF A LA DEMANDE DE BREVET EUROPEEN NO.**  EP 02 29 2890

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-05-2003

| Document brevet cité au rapport de recherche | | Date de publication | Membre(s) de la famille de brevet(s) | | Date de publication |
|---|---|---|---|---|---|
| US 5339459 | A | 16-08-1994 | AUCUN | | |
| US 4323796 | A | 06-04-1982 | AUCUN | | |
| US 5017924 | A | 21-05-1991 | FR | 2646741 A1 | 09-11-1990 |
| | | | EP | 0398778 A1 | 22-11-1990 |
| | | | JP | 2304799 A | 18-12-1990 |
| US 5187390 | A | 16-02-1993 | AUCUN | | |

EPO FORM P0460

Pour tout renseignement concernant cette annexe : voir Journal Officiel de l'Office européen des brevets, No.12/82

15